Europäisches Patentamt

(19) European Patent Office

Office européen des brevets

(11) Veröffentlichungsnummer : **0 150 037**
**B1**

(12) **EUROPÄISCHE PATENTSCHRIFT**

(45) Veröffentlichungstag der Patentschrift :
**27.07.88**

(21) Anmeldenummer : **85100364.0**

(22) Anmeldetag : **16.01.85**

(51) Int. Cl.⁴ : **H 03 D  7/12**

(54) **Bandabhängig schaltbare VHF-Mischerschaltungsanordnung.**

(30) Priorität : **20.01.84 DE 3401863**

(43) Veröffentlichungstag der Anmeldung :
**31.07.85 Patentblatt 85/31**

(45) Bekanntmachung des Hinweises auf die Patenterteilung : **27.07.88 Patentblatt 88/30**

(84) Benannte Vertragsstaaten :
**AT BE CH DE FR GB IT LI LU NL SE**

(56) Entgegenhaltungen :
**DE-A- 1 924 680**
**DE-A- 2 849 178**
**FR-A- 2 322 481**
**US-A- 4 361 910**
**Q.S.T. AMATEUR RADIO, Band 58, Nr. 7, Juli 1974, Seiten 19-24,147, Newington, US; DOUG DE MAW u.a.: "Learning to work with semiconductors"**

(73) Patentinhaber : **Deutsche Thomson-Brandt GmbH Hermann-Schwer-Strasse 3 Postfach 1307 D-7730 Villingen-Schwenningen (DE)**

(72) Erfinder : **Maier, Gerhard Reutestrasse 19 D-7735 Dauchingen (DE)**
Erfinder : **Fischer, Bertram Reuteweg 17 D-7212 Deisslingen (DE)**
Erfinder : **Kirschner, Erich Drosselstrasse 10 D-7210 Göllsdorf (DE)**

EP 0 150 037 B1

## Beschreibung

Die Erfindung betrifft eine Mischerschaltungsanordnung für die Bänder I und III nach dem Oberbegriff des ersten Anspruchs.

Diese Mischerschaltung ist bei Fernsehempfängern weit verbreitet. In Europa wie auch in USA treten im für CATV erweiterten Band I außerordentlich störende Erscheinungen auf, die sich als Moiré bemerkbar machen. In Europa wird der Kanal Y in Kabelnetzen verteilt und besitzt eine Bildträgerfrequenz von 76,25 MHz. Dabei entsteht als Mischergebnis eine Störfrequenz von 37,35 MHz, was im Videobereich einer als Moiré sichtbaren Störfrequenz von 1,55 MHz entspricht.

Aus

$$2 \times BT - F_{OSZ} = F_{STÖR}$$

ergibt sich : $2 \times 76,25$ MHz $- 115,15$ MHz $= 37,35$ MHz.

Daraus wird deutlich, daß dieser Sender sich selbst stört ohne Mitwirkung anderer Sender.

In USA erzeugt der Kanal 6 « Colorbeat », der als Antenne « OFF AIR Info » ebenfalls im Band I vorhanden ist, eine sich selbst störende Moiré-Frequenz von 0,75 MHz im Video-Bereich. Das ergibt sich aus

$$2 \times BT - F_{OSZ} = F_{STÖR}$$

$$2 \times 83,25 \text{ MHz} - 124,5 \text{ MHz} = 42 \text{ MHz} .$$

Zur Lösung dieses Problems der Moiré-Störung wurde gemäß der DE-A-1924 680, Seite 5 mittlerer Absatz, eine kapazitive Rückführung mittels Kondensator 54 von der ZF-Seite der Mischstufe zur Basis des Mischtransistors 24 vorgesehen sowie angegeben, daß der für den Arbeitspunkt des Mischtransistors 24 verantwortliche Widerstand 34 bezüglich der Dämpfung unerwünschter Mischprodukte optimiert werden kann, vergleiche Seite 6, oberster Absatz. Bei dieser bekannten Lösung ergibt allerdings die Rückführung über die Kapazität 54 offenbar eine unerwünschte Abhängigkeit von der Frequenz.

Der Erfindung lag somit die Aufgabe zugrunde diese Störungen zu beseitigen, ohne diesen Nachteil in Kauf nehmen zu müssen.

Gelöst wird diese Aufgabe für eine Mischerschaltungsanordnung nach dem Oberbegriff des ersten Anspruchs durch die erfindungsgemäße Ausbildung gemäß dem Kennzeichen.

Einzelheiten sind den nachfolgenden Ansprüchen und der Beschreibung eines Ausführungsbeispiels zu entnehmen.

Nach der Erfindung wird vom « heißen » Punkt des Widerstandes, der die Versorgungsspannung dem zweiten Kreis des ZF-Band-filters zuleitet, über einen Rückführungs-Widerstand zur Basis des Transistors eine Gegenkopplung wirksam und gleichzeitig mittels des so an der Basis wirkenden Spannungsteilers der Kollektorstrom reduziert. Als Folge davon werden für das Band I die Mischprodukte vorteilhafterweise um 60 dB abgesenkt. Dadurch bleiben die beiden Störfrequenzen so wirksam geschwächt, daß sie sich nicht mehr auswirken können. Bei Betrieb des Mischers im Band III wird von der entsprechenden Schaltspannung über eine Reihenschaltung einer Diode und eines Widerstandes das Basisniveau derart angehoben, daß sich ein für das Band III erforderlicher Strom einstellt.

In einer Zeichnung ist die Mischerschaltungsanordnung beispielhaft für einen VHF-Mischer für das Band I und III dargestellt.

Der Mischer-Transistor 1 arbeitet über den Kollektor-Widerstand 2 auf ein zweikreisiges Bandfilter 13. Die Kollektorspannung wird über den Widerstand 4 vom Anschluß 8 für + 12 V zugeführt. Am Anschluß 9 wird die ZF-Spannung zur weiteren Verstärkung abgenommen. Am Anschluß 11 wird die HF vom Vorverstärker zugeführt. Über den Anschluß 7 wird die Oszillatorspannung der Basis zugeleitet. Zwischen dem « heißen » Ende des Widerstandes 4 und der Basis liegt ein Rückführungs-Widerstand 3, der als Gegenkopplung wirkt und gleichzeitig mittels des an der Basis wirkenden Spannungsteilers, bestehend aus dem Rückführungs-Widerstand 3 und dem Basiswiderstand 10, den Kollektorstrom auf einen Wert zwischen 0,3 und 0,6 mA reduziert. Durch diese Verringerung des Mischerstroms wird die Eigenstörung im Kanal Y des für CATV erweiterten Bandes I in Europa ebenso wie die Eigenstörung der Antennen « OFF AIR Info » in USA im Bereich des Bandes I um 60 dB abgesenkt. Im Band III wird dem Mischer über die Reihenschaltung aus Diode 6 und Widerstand 5 über den Anschluß 12 eine entsprechende Schaltspannung zugeführt und dabei das Basisniveau so angehoben, daß sich der für dieses Band erforderliche Mischerstrom einstellt. Im Band III sind Eigenstörungen bei Anwesenheit eines Signals nicht vorhanden.

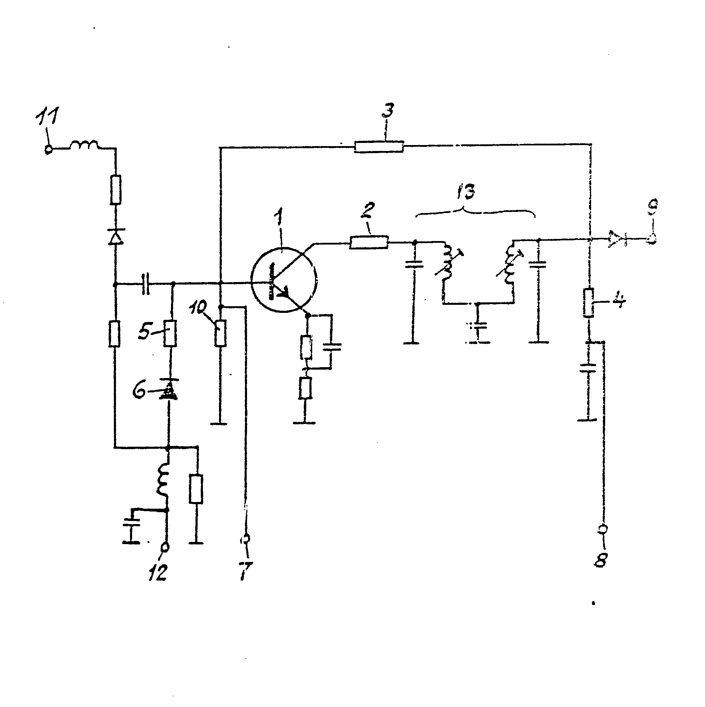

## Patentansprüche

1. Mischerschaltungsanordnung für die VHF-Fernsehbänder I und III, die bandabhängig geschaltet ist und einen Transistor (1) aufweist, der über einen Kollektorwiderstand (2) auf ein zweikreisiges ZF-Bandfilter (13) arbeitet, wobei die Kollektorspannung dem Bandfilter (13) über einen Widerstand (4) zugeführt wird, dadurch gekennzeichnet, daß zwischen der Verbindungsstelle von Bandfilter (13) und Widerstand (4) und der Basis des Transistors (1) ein Rückführungs-Widerstand (3) eingefügt ist, der mit dem Basiswiderstand (10) des Transistors (1) einen Spannungsteiler bildet, der so dimensioniert ist, daß der Mischerstrom derart abgesenkt ist, daß Eigenstörungen im Band I unterdrückt werden, während bei Betrieb im Band III von der Schaltspannung für Band III über eine Reihenschaltung einer Diode (6) und eines Widerstandes (5) das Basisniveau des gleichen Mischtransistors (1) auf einen gegenüber dem Betrieb im Band I höheren Mischerstrom-Wert angehoben wird.

2. Mischerschaltungsanordnung gemäß Anspruch 1, dadurch gekennzeichnet, daß der Mischerstrom bei Betrieb im Band I auf eine Wert von 0,3 bis 0,6 mA abgesenkt wird.

### Claims

1. A mixing circuit configuration for the VHF television bands I and III, which switches depending on the band and has a transistor (1) which operates across a collector resistor (2) on a two-circuit intermediate frequency band-pass filter (13), in which the collector voltage is fed to the band-pass filter (13) across a resistor (4), characterized in that a feedback resistor (3) is interposed between the junction of the band-pass filter (13) and resistor (4) and the base of the transistor (1), thus forming a voltage divider with the base resistor (10) of the transistor (1), which is dimensioned so that the mixer current is reduced to suppress internal disturbances in band I, while during operation in band III the base level of the same mixing transistor (1) is increased by the switching voltage for band III to a mixer current value that is greater than operation in band I, by means of a series connection of a diode (6) and a resistor (5).

2. A mixing circuit configuration as claimed in Claim 1, characterized in that the mixer current during operation in band I is reduced to a value of 0.3 to 0.6 mA.

### Revendications

1. Circuit mélangeur pour les bandes de télévision VHF I et III, mis en circuit en fonction des bandes et comportant un transistor (1) qui, par une résistance de collecteur (2), attaque un filtre de bande à deux circuits (13), la tension de collecteur étant amenée au filtre de bande (13) par une résistance (4), caractérisé par le fait qu'entre le point commun du filtre de bande (13) et de la résistance (4) et la base du transistor (1), une résistance de rétro-couplage (3) est intercalée et forme avec la résistance de base (10) du transistor (1) un diviseur de tension, dimensionné pour réduire le courant du mélangeur de sorte à supprimer l'auto-parasitage dans la bande I, tandis que lors du fonctionnement dans la bande III, la tension de commutation en bande III fait augmenter en passant par le circuit série comportant une diode (6) et une résistance (5), le niveau de base du même transistor mélangeur (1) à une valeur de courant de mélangeur supérieure par rapport au fonctionnement dans la bande I.

2. Circuit mélangeur selon la revendication 1, caractérisé par le fait que le courant du mélangeur lors du fonctionnement dans la bande I, est réduit à une valeur comprise entre 0,3 et 0,6 mA.